# EUROPEAN PATENT APPLICATION

(11) **EP 1 672 686 A2**
(43) Date of publication of application: **21.06.2006**
(21) Application number: 05026748.3
(22) Date of filing: 07.12.2005
(51) Int. Cl.: H01L 21/673

(54) **Storage container for semiconductor wafers**

(30) Priority: 15.12.2004 JP 2004363258
(71) Applicant: Miraial Co., Ltd., Tokyo (JP)
(72) Inventor: Obayashi, Tadahiro, Shisui-machi Kikuchi-shi Kumamoto-ken (JP)
(74) Representative: Grünecker, Kinkeldey, Stockmair & Schwanhäusser Anwaltssozietät

(57) **Abstract**

The invention is a storage container in which semiconductor wafers and the like are stored in a container main body 11. The container main body 11 includes an attaching/detaching mechanism portion 23 in which a handle 21 and a top flange 13 are provided while detachably mounted onto the container main body 11. The attaching/detaching mechanism portion 23 includes a fitting plate 27 and a lock portion28. The fitting plate 27 is directly fitted in a fitted portion on the side of the container main body 11, and the lock portion 28 fixes the fitting plate 27 while the fitting plate 27 is fitted in the fitted portion. The lock portion 28 includes a fitting hole 34, a rocking piece 36, and a stopper 37. The fitting hole 34 is provided on the side of the container main body 11. The rocking piece 36 is rockably provided on the side of the fitting plate 27, and the rocking piece 36 has a fitting pawl 35 in one end portion. The fitting pawl 35 is fitted in the fitting hole 34. The stopper 37 performs fixing in the state in which the rocking piece 36 is rocked to one side to fit the fitting pawl 35 in the fitting hole 34 and in the state in which the rocking piece 36 is rocked to the other side to disengage the fitting pawl 35 from the fitting hole 34. Therefore, workability can be improved during washing and drying.

## Description

### BACKGROUND OF THE INVENTION

The present invention relates to a storage container which is used for transport, keeping, and shipment of a stored object such as semiconductor wafers while the stored object is stored therein, and particularly to the storage container equipped with a handle with which an operator elevates the storage container or a flange with which an apparatus automatically elevates the storage container.

The storage container used for the storage and transport of the semiconductor wafers and the like is generally known. The operator manually elevates or moves the storage container while a plurality of semiconductor wafers or the like are placed in the storage container.

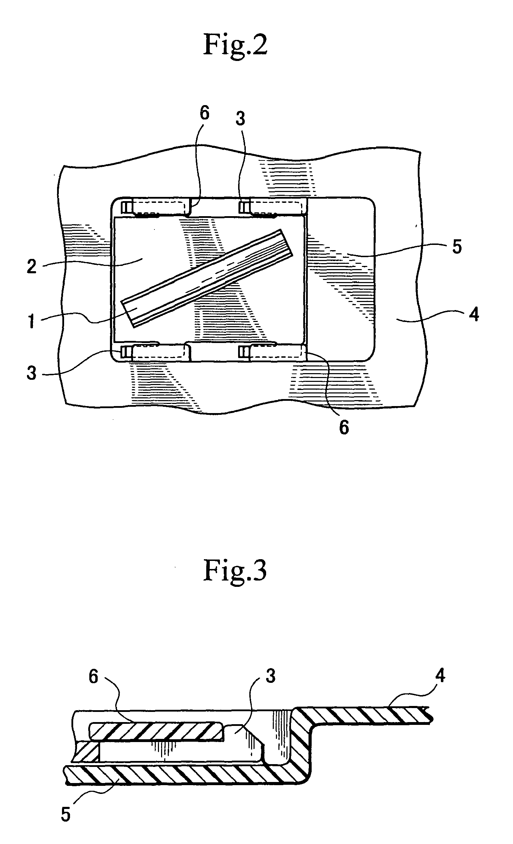

The handle with which an operator manually holds the storage container is provided in the storage container. For example, the handle is disclosed in Japanese Patent Laid-Open No. 11-91864. Figs. 2 and 3 show the handle disclosed in Japanese Patent Laid-Open No. 11-91864.

The handle includes a grasp portion 1 and a plane portion 2. Four wedge members 3 are provided on both sides of the plane portion 2. A concave groove portion 5, into which the plane portion 2 is fitted, is provided in a sidewall 4 of a container main body. Engagement members 6 are provided at four points on both sides of the groove portion 5.

According to this structure, in the handle, the plane portion 2 is fitted in the groove portion 5 and shifted in the groove portion 5, and thereby the plane portion 2 is fitted onto the container main body side while supported by the engagement members 6. At this point, the wedge members 3 latch the engagement members 6 to prevent the plane portion 2 from falling out from the groove portion 5.

However, in the handle of the storage container having the above configuration, after the wedge members 3 latch the engagement members 6, it is not easy that the wedge members 3 disengage the engagement members 6 to detach the handle from the container main body. Like the storage container used for the transport of the semiconductor wafers, in the case of the storage container in which washing is required after the storage container is used for the transport once, the handle is detached to perform the washing. However, because the handle is not easy to detach, there is a problem that workability is not good.

### SUMMARY OF THE INVENTION

In view of the foregoing, an object of the invention is to provide a storage container in which the handle is easily detached. A storage container according to the invention which is transported and kept while a stored object is stored in a container main body, the storage container includes an attaching/detaching mechanism portion in which one of or both a handle with which the container main body is manually elevated and a flange with which the container main body is automatically elevated are provided in the container main body while one of or both the handle and the flange are detachably mounted onto the container main body, wherein the attaching/detaching mechanism portion includes a fitting plate which is directly fitted in a fitted portion on the container main body side and a lock portion which fixes the fitted portion while the fitting plate is fitted in the fitted portion.

In the storage container, the lock portion is configured to include a first fitting hole or a first fitting pawl, a rocking piece, and a stopper, the first fitting hole or the first fitting pawl being provided on the container main body side, the rocking piece having a second fitting pawl or a second fitting hole in one end portion while rockably provided on the fitting plate side, the second fitting pawl or the second fitting hole being fitted in the first fitting hole or the first fitting pawl, the stopper fixes the rocking piece in a state in which the rocking piece is rocked toward one side to fit the fitting pawl in the fitting hole and in a state in which the rocking piece is rocked toward the other side to disengage the fitting pawl from the fitting hole.

In the above configuration, the lock portion fixes the fitting plate by fitting the fitting plate of the attaching/detaching mechanism portion of the handle into the fitted portion on the container main body side. In the lock portion, the rocking piece is rocked toward one side to fit the fitting pawl in the fitting hole. At this point, the rocking piece is fixed by the stopper while rocked toward one side, which allow the handle to be securely fixed onto the container main body side. When the handle is detached, the rocking piece is rocked toward the other side. At this point, the rocking piece is fixed by the stopper while rocked to the other side, which allows the rocking piece to be released from the fixed state to disengage the fitting plate from the fitted portion.

The lock portion may be configured to include a fitting pawl, a flexible plate, and a knob, the fitting pawl being provided on the container main body side, the flexible plate having flexibility, the flexible plate having a fitting hole in a leading end portion while a base end portion of the flexible plate being provided on the fitting plate side, the fitting hole being fitted in the fitting pawl, the knob releasing the fixed state by bending the flexible plate to disengage the fitting pawl from the fitting hole.

In the above configuration, when the fitting plate of the attaching/detaching mechanism portion of the handle is fitted into the fitted portion on the container main body side, the flexible plate is bent to fit the fitting pawl in the fitting hole. When the fitting plate is disengaged from the fitted portion, the knob is held to bend the flexible plate, and the fitting pawl is disengaged from the fitting hole to release the fixed state. In this state of things, the fitting plate is shifted and disengaged from the fitted portion.

Alternatively, the lock portion may be configured to include a main-body-side flexible piece, a handle-side fitting plate, and a knob, the main-body-side flexible piece having flexibility, the main-body-side flexible plate having a fitting pawl in a leading end portion while a base end portion of the flexible plate being provided on the container main body side, the handle-side fitting plate having a fitting hole in a leading end portion while a base end portion of the handle-side fitting plate being provided on the fitting plate side, the fitting pawl being fitted in the fitting hole, the knob releasing the fixed state by bending the main-body-side flexible plate to disengage the fitting pawl from the fitting hole.

In the above configuration, when the fitting plate of the attaching/detaching mechanism portion of the handle is fitted into the fitted portion on the container main body side, the main-body-side flexible plate is bent to fit the fitting pawl in the fitting hole. When the fitting plate is disengaged from the fitted portion, the knob is held to bend the main-body-side flexible piece, and the fitting pawl is disengaged from the fitting hole to release the fixed state. In this state of things, the fitting plate is shifted and disengaged from the fitted portion.

### BRIEF DESCRIPTION OF THE DRAWINGS

Fig. 1 is a front view showing a handle according to a first embodiment of the invention;
Fig. 2 is a front view showing a handle of a conventional storage container;
Fig. 3 is a sectional view showing the handle of the conventional storage container;
Fig. 4 is a perspective view showing a container main body of a storage container according to the first embodiment of the invention;
Fig. 5 is a perspective view showing the container main body of the storage container according to the first embodiment of the invention;
Fig. 6 is a partially sectional side view showing the handle according to the first embodiment of the invention;
Fig. 7 is a schematic view explaining an operation of a lock portion according to the first embodiment of the invention;
Fig. 8 is a perspective view showing a lock portion according to a second embodiment of the invention;
Fig. 9 is a sectional view showing the lock portion according to the second embodiment of the invention;
Fig. 10 is a perspective view showing a lock portion according to a third embodiment of the invention; and
Fig. 11 is a sectional view showing the lock portion according to the third embodiment of the invention.

### DESCRIPTION OF THE PREFERRED EMBODIMENT

Preferred embodiments of the invention will be described below with reference to the accompanying drawings.

### (First Embodiment)

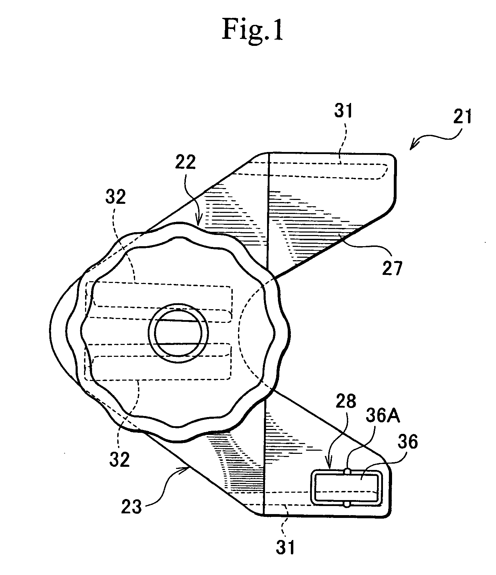

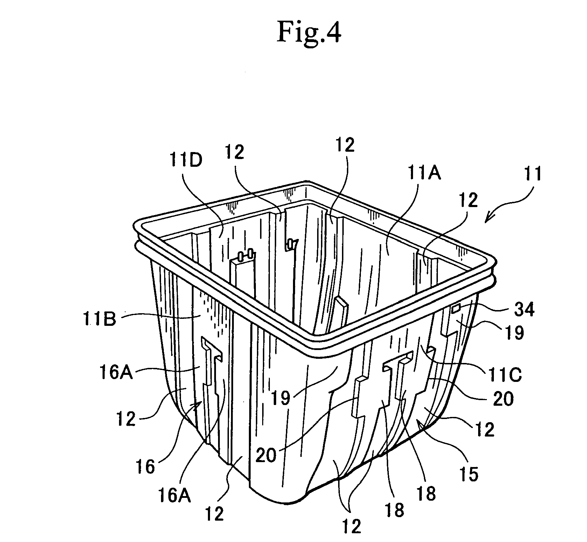

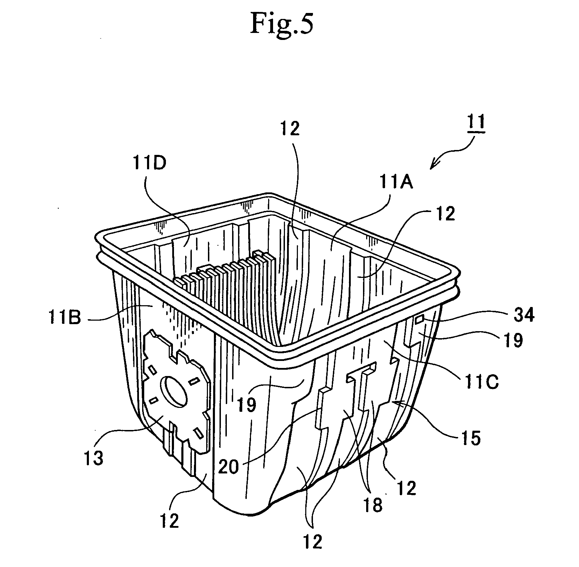

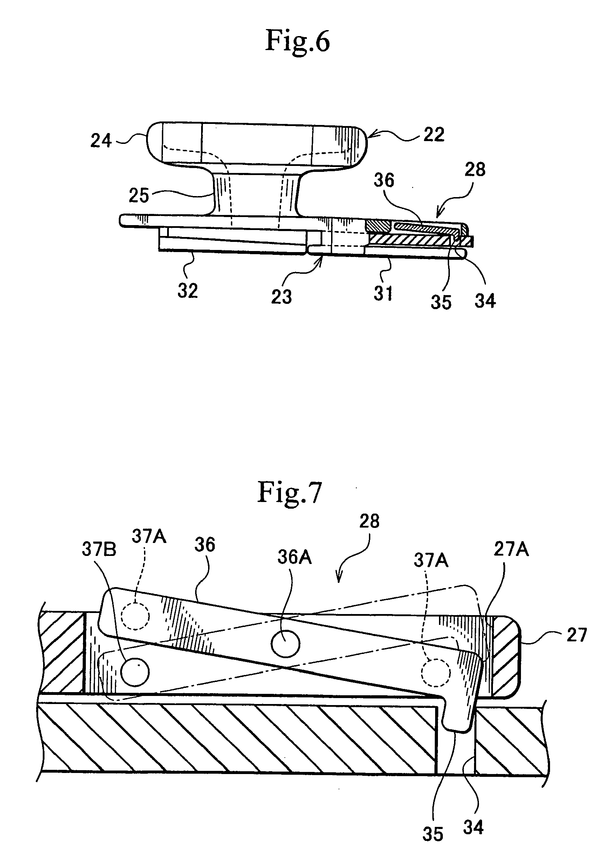

In a first embodiment, a storage container in which the semiconductor wafers are stored as a stored object will be described as an example. Fig. 1 is a front view showing a handle according to the first embodiment, Fig. 4 is a perspective view showing a container main body of a storage container according to the first embodiment, Fig. 5 is a perspective view showing the container main body of the storage container according to the first embodiment, Fig. 6 is a partially sectional side view showing the handle according to the first embodiment, and Fig. 7 is a schematic view explaining an operation of a lock portion.

The storage container according to the first embodiment mainly includes a container main body 11 and a lid unit (not shown). The semiconductor wafers are stored in the container main body 11. The lid unit is attached to the container main body 11 to seal the inside of the container main body 11.

The lid unit is formed in a shape of a rectangular plate, and the lid unit is attached to the container main body 11 from the upper side of the container main body 11 to seal the inside of the container main body 11. The lid unit includes fixing means for fixing the lid unit to the container main body 11. Examples of the fixing means include manually fixing means such as a hook and fixing means for automatically attaching and detaching the lid unit with an attaching/detaching apparatus. The invention can be applied to both the types.

As shown in Figs. 4 and 5, the container main body 11 is substantially formed in a cube as a whole. The container main body 11 includes four sidewalls 11A, 11B, 11C, and 11D and a bottom plate (not shown) in a vertical posture (in the state shown in Figs. 4 and 5). The four sidewalls 11A, 11B, 11C, and 11D and the bottom plate become the surrounding walls. Reinforcement longitudinal grooves 12 are provided in each of the sidewalls 11A, 11B, 11C, and 11D. The container main body 11 is placed in a horizontal posture as needed in a production line of the semiconductor wafer. Positioning means (not shown) is provided in an outside surface of the sidewall 11A which becomes a bottom portion when the storage container is placed in the horizontal posture. A top flange 13 for a wafer transport apparatus is detachably mounted in the outside surface of the sidewall 11B which becomes a ceiling portion when the storage container is placed in the horizontal posture. Handle mounting portions 15 are provided in the outside surfaces of the sidewalls 11C and 11D which become transverse wall portions when the storage container is placed in the horizontal posture, and a handle 21 (see Fig. 1) is detachably mounted on the handle mounting portion 15. A flange mounting portion 16 is provided in the outside surface of the sidewall 11B which becomes an upper wall portion when the storage container is placed in the horizontal posture, and the top flange 13 is detachably mounted on the flange mounting portion 16.

The handle mounting portion 15 includes two inside flange portions 18, two outside flange portions 19, and two intermediate flange portions 20. The two inside flange portions 18 are provided in the central longitudinal groove 12 among the three longitudinal grooves 12 of each of the sidewalls 11C and 11D. The two inside flange portions 18 are locked in two inside lock plates 32 of a later-mentioned handle 21 respectively. The two inside flange portions 18 are arranged so as to oppose each other. The two outside flange portions 19 are provided in the longitudinal grooves 12 on the both sides. The two outside flange portions 19 are locked in two outside lock plates 31 of the later-mentioned handle 21 respectively. The outside flange portion 19 is provided in an outside wall of each of the longitudinal grooves 12 on the both sides, and the two outside flange portions 19 are arranged so as to oppose each other. A fitting hole 34 into which a fitting pawl 35 of a lock portion 28 is fitted is provided in one (right side in the drawings) of the outside flange portions 19. The two intermediate flange portions 20 are provided at positions opposite the inside flange portion 18 in the longitudinal grooves 12 on the both sides. The intermediate flange portion 20 is rocked in the handle of another structure.

The flange mounting portion 16 includes two flange portions 16A. The two flange portions 16A are provided in the central longitudinal groove 12 of the sidewall 11B while opposing each other.

The handle 21 is a member which is grasped by the operator when the operator elevates or carries the storage container. As shown in Figs. 1, 6, and 7, the handle 21 mainly includes a grasp portion 22 and an attaching/detaching mechanism portion 23. The operator manually grasps the grasp portion 22, and the attaching/detaching mechanism portion 23 is detachably mounted on the both sides of container main body 11.

The grasp portion 22 includes a disc portion 24 and a cylindrical coupling portion 25. The operator manually grasps the disc portion 24, and the cylindrical coupling portion 25 integrally fixes the disc portion 24 to the attaching/detaching mechanism portion 23.

The attaching/detaching mechanism portion 23 includes a fitting plate 27 and a lock portion 28. The fitting plate 27 is fitted on the side of container main body 11. The lock portion 28 is rocked on the side of the container main body 11 to fix the handle while the fitting plate 27 is fitted in the handle mounting portion 15 of the container main body 11.

The fitting plate 27 is formed in a V-shape as a whole. In the fitting plate 27, outside lock plates 31 are formed in both end portions respectively, and inside lock plates 32 are formed in the central portion. The outside lock plate 31 and the inside lock plate 32 are formed at the positions where the outside lock plate 31 and the inside lock plate 32 align the outside flange portion 19 and the inside flange portion 18 of the handle mounting portion 15 respectively. The outside lock plate 31 is formed in an L-shape in a cross section, and the outside lock plate 31 supports the outside flange portion 19 so as to sandwich the outside flange portion 19 between the fitting plate 27 and the outside lock plate 31. Similarly to the outside lock plate 31, the inside lock plate 32 is formed in an L-shape in the cross section, and the inside lock plate 32 supports the inside flange portion 18 so as to sandwich the inside flange portion 18 between the fitting plate 27 and the inside lock plate 32.

The lock portion 28 is provided in one of end portions of the fittingplate 27. The lockportion 28 includes a fitting hole 34, a rocking piece 36, and a stopper 37. The fitting hole 34 is provided on the side of the container main body 11. The rocking piece 36 is rockably provided on the side of the fitting plate 27 of the handle 21, and the rocking piece 36 has a fitting pawl 35 in one of end portions. The fitting pawl 35 is fitted in the fitting hole 34. The stopper 37 fixes the rocking piece 36.

The fitting hole 34 is one in which the fitting pawl 35 is fitted. The fitting hole 34 is provided in one of the outside flange portions 19 of the container main body 11.

The rocking piece 36 is a plate member which is rocked to engage and disengage the lock. A square mounting hole 27A is made in one end of the fitting plate 27, so that the rocking piece 36 is mounted in the mounting hole 27A. The rocking piece 36 is rockably supported by a rotating shaft 36A while mounted in the mounting hole 27A. The fitting pawl 35 is provided in one end portion (right-side end portion in Fig. 7) of the rocking piece 36. The fitting pawl 35 is fitted in the fitting hole 34 by rocking the rocking piece 36.

The stopper 37 fixes the rocking piece 36 in the state (state shown by a solid line in Fig. 7) in which the fitting pawl 35 is fitted in the fitting hole 34 by rocking the rocking piece 36 to one side and in the state (state shown by an alternate long and short dash line in Fig. 7) in which the fitting pawl 35 is disengaged from the fitting hole 34 by rocking the rocking piece 36 to the other side. The stopper 37 includes four hemispherical projections 37A and four hemispherical recesses 37B. The hemispherical projections 37A are provided back and forth in both side faces of the rocking piece 36, and the hemispherical projections 37A are fitted in the hemispherical recesses 37B respectively. In an inner wall of the mounting hole 27A, the hemispherical recesses 37B are provided at the, positions where the rocking piece 36 is fixed by fitting the hemispherical projections 37A in the hemispherical recesses 37B while the rocking piece 36 is rocked to one side to fit the fitting pawl 35 in the fitting hole 34, and the hemispherical recesses 37B are also provided at the positions where the rockingpiece 36 is fixed by fitting the hemispherical projections 37A in the hemispherical recesses 37B while the rocking piece 36 is rocked to the other side to disengage the fitting pawl 35 from the fitting hole 34.

The top flange 13 includes a grasp portion 13A and a fitting plate (not shown). The grasp portion 13A is caught by an arm portion of a transport apparatus (not shown). The fitting plate is integrally provided with the grasp portion 13A, and the fitting plate is fitted in the flange mounting portion 16. A lock plate (not shown) having the L-shape in the cross section and a lock portion (not shown) having the same configuration as the lock portion 28 are provided in the fitting plate. The lock plate is fitted in the flange portion 16A of the flange mounting portion 16.

### (Operation)

In the storage container having the above configuration, the handle 21 and the top flange are attached and detached in the following manner.

When the storage container is transported while the semiconductor wafers are stored therein, the handle 21 and the top flange 13 are detached in order to wash the storage container.

In this case, first, the rocking piece 36 of the lock portion 28 is pressed by a finger of the operator, which rocks the rocking piece 36 to become the state shown by the alternate long and short dash line in Fig. 7. Then, the rocking piece 36 is fixed by the stopper 37. Therefore, the lock of the handle 21 is disengaged. In this state of things, the handle 21 is disengaged from the container main body 11 when the handle 21 is shifted downward. The top flange 13 is also disengaged in the same manner.

Then, the container main body 11, the top flange 13, the handle 21, and the like are washed with pure water or the like and dried.

Then, the outside lock plate 31 and the inside lock plate 32 of the handle 21 are shifted upwards while inserted in the longitudinal grooves 12, and the outside lock plate 31 and the inside lock plate 32 are fitted in the inside flange portion 18 and the outside flange portion 19. When the rocking piece 36 of the lock portion 28 is rocked by pressing the rocking piece 36 with the finger, the rocking piece 36 becomes the state shown by the solid line in Fig. 7, and the rocking piece 36 is fixed by the stopper 37. Therefore, the fitting pawl 35 is fitted in the fitting hole 34 to fix the handle 21 to the container main body 11.

The top flange 13 is also fixed in the same manner.

Thus, the rocking piece 36 is fixed by the stopper 37 while the fitting pawl 35 is attached to and detached from the fitting hole 34 by rocking the rocking piece 36, so that the fixing and the disengagement from the fixed state can securely be performed and the fitting plate 27 can easily be engaged to and disengaged from the fitted portion on the side of the container main body 11. As a result, the handle 21 can easily be attached to and detached from the container main body 11, and the efficiency of the washing working of the storage container and the like can be improved.

### (Second Embodiment)

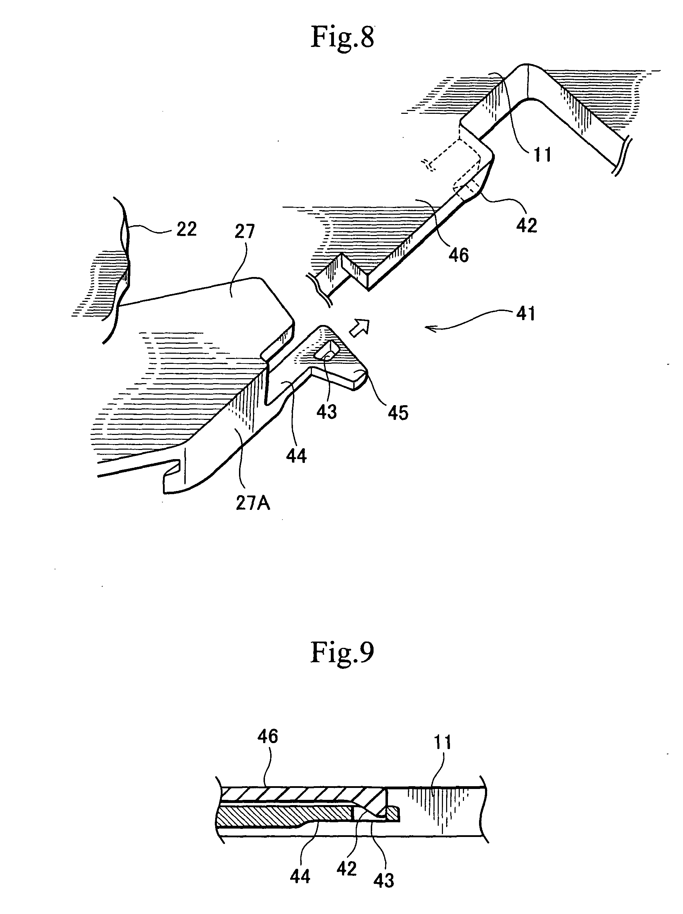

Then, a second embodiment of the invention will be described with reference to Figs. 8 and 9.

The entire configuration of the storage container according to the second embodiment is similar to the first embodiment. Therefore, the same component is designated by the same numeral, the description of the same component will be omitted, and only the feature part of the second embodiment will be described.

In the second embodiment, the lock portion is modified. A lock portion 41 of the second embodiment includes a fitting pawl 42, a fitting hole 43, a flexible plate 44, and a knob 45.

The fitting pawl 42 is a member which is fitted in the fitting hole 43 of the flexible plate 44. The fitting pawl 42 is provided on a lower side of a flange portion 46 provided on the side of the container main body 11.

The fitting hole 43 is a hole in which the fitting pawl 42 is fitted to fix the handle. The fitting hole 43 is provided at a leading end of the flexible plate 44.

The flexible plate 44 is a member which supports the fitting pawl 42 while the fitting pawl 42 is fitted in the fitting hole 43. The flexible plate 44 is formed by a plate material having flexibility, and a base end portion of the flexible plate 44 is provided on the side of the fitting plate 27. That is, the base end portion of the flexible plate 44 is supported by a vertical plate portion 27Awhich is vertically bent from an end portion of the fitting plate 27. Therefore, there is a constant gap between the flexible plate 44 and the fitting plate 27, and the flange portion 46 is inserted into the gap. The fitting hole 43 is provided in a leading end portion of the flexible plate 44, and the fitting pawl 42 is fitted in the fitting hole 43.

The knob 45 is a member which disengages the lock. The knob 45 is provided at the leading end of the flexible plate 44, and the fixed state is released by bending the flexible plate 44 to disengage the fitting pawl 42 from the fitting hole 43.

In the storage container of the second embodiment having the above configuration, when the flange portion 46 on the side of the container main body 11 is fitted between the flexible plate 44 and the fitting plate 27 of the attaching/detaching mechanism portion 23 of the handle 21, the flexible plate 44 is bent to fit the fitting pawl 42 in the fitting hole 43, which locks the handle.

When the fitting plate 27 is disengaged, the knob 45 is pressed to bend the flexible plate 44, and the fitting pawl 42 is disengaged from the fitting hole 43 to release the fixed state. In this state of things, the fitting plate 27 is shifted to disengage the fitting plate 27.

Therefore, the fitting pawl 42 is fitted in the fitting hole 43 to perform the fixing by bending the flexible plate 44, or the fitting pawl 42 is disengaged from the fitting hole 43 to release the fixed state by bending the flexible plate 44, and thereby the fitting plate 27 is engaged to and disengaged from the fitted portion, so that, similarly to the first embodiment, the handle 21 can easily be attached to and detached from container main body 11, and the efficiency of the washing working of the storage container and the like can be improved.

### (Third Embodiment)

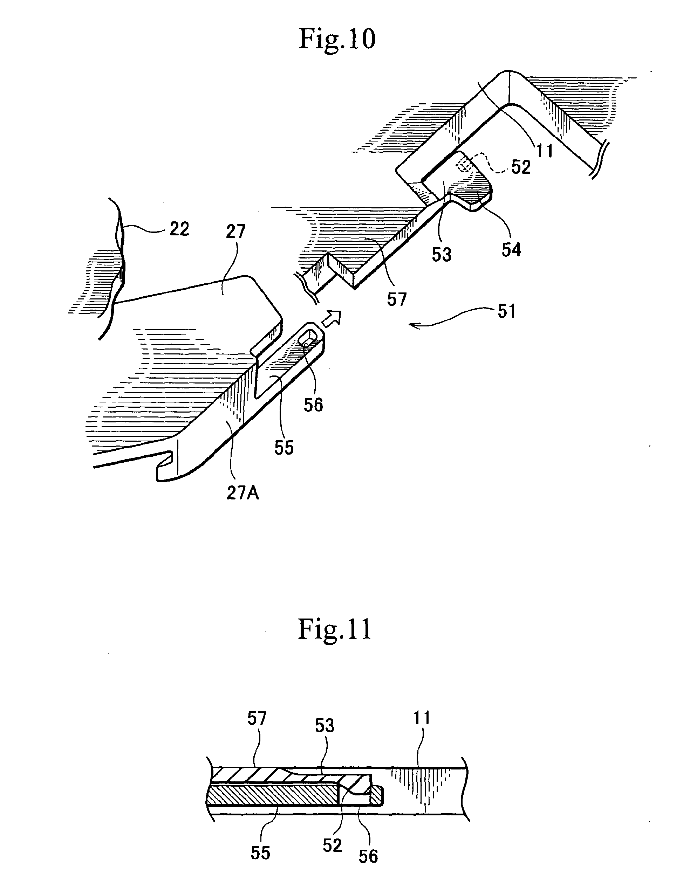

Then, a third embodiment of the invention will be described with reference to Figs. 10 and 11.

The entire configuration of the storage container according to the third embodiment is similar to the first embodiment. Therefore, the same component is designated by the same numeral, the description of the same component will be omitted, and only the feature part of the third embodiment will be described.

In the third embodiment, the lock portion is modified. A lock portion 51 of the third embodiment includes a fitting pawl 52, a main-body-side flexible piece 53, a knob 54, a handle-side fitting plate 55, and a fitting hole 56.

The fitting pawl 52 is a member which is fitted in the fitting hole 56 of the handle-side fitting plate 55. The fitting pawl 52 is provided on a lower side of the main-body-side flexible piece 53.

The main-body-side flexible piece 53 is a member which supports the fitting pawl 52 while the fitting pawl 52 is fitted in the fitting hole 56. The main-body-side flexible piece 53 is formed by the plate material having flexibility, and the base end portion of the main-body-side flexible piece 53 is provided in a flange portion 57 provided on the side of the container main body 11.

The knob 54 is a member which disengages the lock. The knob 54 is provided at the leading end of the main-body-side flexible piece 53, and the fixed state is released by bending the main-body-side flexible piece 53 to disengage the fitting pawl 52 from the fitting hole 56.

The handle-side fitting plate 55 is a member which supports the fitting pawl 52 while the fitting hole 56 is provided at the leading end. The fitting pawl 52 is fitted in the fitting hole 56. The handle-side fitting plate 55 is supported by the vertical plate portion 27B which is vertically bent from the end portion of the fitting plate 27. Therefore, there is the constant gap between the handle-side fitting plate 55 and the fitting plate 27, and the flange portion 57 is inserted into the gap.

In the storage container of the third embodiment having the above configuration, when the flange portion 57 on the side of the container main body 11 is fitted between the handle-side fitting plate 55 and the fitting plate 27 of the attaching/detaching mechanism portion 23 of the handle 21, the main-body-side flexible piece 53 is bent to fit the fitting pawl 52 in the fitting hole 56, which locks the handle.

When the fitting plate 27 is disengaged, the knob 54 is pulled to bend the main-body-side flexible piece 53, and the fitting pawl 52 is disengaged from the fitting hole 56 to release the fixed state. In this state of things, the fitting plate 27 is shifted to disengage the fitting plate 27.

Therefore, the fitting pawl 52 is fitted in the fitting hole 56 to perform the fixing by bending the main-body-side flexible piece 53, or the fitting pawl 52 is disengaged from the fitting hole 56 to release the fixed state by bending the main-body-side flexible piece 53, and thereby the fitting plate 27 is engaged to and disengaged from the fitted portion, so that the handle can easily be attached to and detached from container main body 11, and the efficiency of the washing working of the storage container and the like can be improved.

### (Modification)

In the above embodiments, the storage container for the semiconductor wafer is described by way of example. However, the invention is not applied only to the embodiments, but the storage container of the invention may be one in which other stored objects are stored. Even in this case, the same actions and effects as for the above embodiments can be achieved.

## Claims

1. A storage container which is transported and kept while a stored object is stored in a container main body,
the storage container comprising an attaching/detaching mechanism portion in which one of or both a handle with which the container main body is manually elevated and a flange with which the container main body is automatically elevated are provided in the container main body while one of or both the handle and the flange are detachably mounted onto the container main body,
wherein the attaching/detaching mechanism portion includes a fitting plate which is directly fitted in a fitted portion on the container main body side and a lock portion which fixes the fitted portion while the fitting plate is fitted in the fitted portion, and
the lockportion is configuredto include a first fitting hole or a first fitting pawl, a rocking piece, and a stopper, the first fitting hole or the first fitting pawl being provided on the container main body side, the rocking piece having a second fitting pawl or a second fitting hole in one end portion while rockably provided on the fitting plate side, the second fitting pawl or the second fitting hole being fitted in the first fitting hole or the first fittingpawl, the stopper fixes the rocking piece in a state in which the rocking piece is rocked to one side to fit the fitting pawl in the fitting hole and in a state in which the rocking piece is rocked to the other side to disengage the fitting pawl from the fitting hole.

2. A storage container which is transported and kept while a stored object is stored in a container main body,
the storage container comprising an attaching/detaching mechanism portion in which one of or both a handle with which the container main body is manually elevated and a flange with which the container main body is automatically elevated are provided in the container main body while one of or both the handle and the flange are detachably mounted onto the container main body,
wherein the attaching/detaching mechanism portion includes a fitting plate which is directly fitted in a fitted portion on the container main body side and a lock portion which fixes the fitted portion while the fitting plate is fitted in the fitted portion, and
the lock portion is configured to include a fitting pawl, a flexible plate, and a knob, the fitting pawl being provided on the container main body side, the flexible plate having flexibility, the flexible plate having a fitting hole in a leading end portion while a base end portion of the flexible plate being provided on the fitting plate side, the fitting hole being fitted in the fitting pawl, the knob releasing the fixed state by bending the flexible plate to disengage the fitting pawl from the fitting hole.

3. A storage container which is transported and kept while a stored object is stored in a container main body,
the storage container comprising an attaching/detaching mechanism portion in which one of or both a handle with which the container main body is manually elevated and a flange with which the container main body is automatically elevated are provided in the container main body while one of or both the handle and the flange are detachably mounted onto the container main body,
wherein the attaching/detaching mechanism portion includes a fitting plate which is directly fitted in a fitted portion on the container main body side and a lock portion which fixes the fitted portion while the fitting plate is fitted in the fitted portion, and
the lock portion is configured to include a main-body-side flexible piece, a handle-side fitting plate, and a knob, the main-body-side flexible piece having flexibility, the main-body-side flexible piece having a fitting pawl in a leading end portion while a base end portion of the flexible plate being provided on the container main body side, the handle-side fitting plate having a fitting hole in a leading end portion while a base end portion of the handle-side fitting plate being provided on the fitting plate side, the fitting pawl being fitted in the fitting hole, the knob releasing the fixed state by bending the main-body-side flexible plate to disengage the fitting pawl from the fitting hole.
